# FASCICULE DE BREVET EUROPEEN

(11) **EP 4 564 035 B1**
(45) Date de publication et mention de la délivrance du brevet: **30.09.2026**
(21) Numéro de dépôt: 24214690.0
(22) Date de dépôt: 22.11.2024
(51) Int. Cl.: G01R 31/392, G01R 31/379, H01M 10/06, H01M 10/48, H05K 7/14

(54) **MÉTHODE ET DISPOSITIF POUR DÉTECTER UNE DÉFAILLANCE D'UNE BATTERIE AU PLOMB**
VERFAHREN UND VORRICHTUNG ZUR ERKENNUNG EINES FEHLERS EINER BLEIBATTERIE
METHOD AND APPARATUS FOR DETECTING FAILURE OF LEAD-ACID BATTERY

(30) Priorité: 29.11.2023 FR 2313233
(43) Date de publication de la demande: 04.06.2025
(73) Titulaire: Commissariat à l'Energie Atomique et aux Energies Alternatives, 75015 Paris (FR)
(72) Inventeur: DESEURE, Jonathan, 38054 GRENOBLE CEDEX 09 (FR); KIRCHEV, Angel, 38054 GRENOBLE CEDEX 09 (FR); KLEIN, Jean-Marie, 38054 GRENOBLE CEDEX 09 (FR)
(74) Mandataire: Santarelli

(56) Documents cités:
- EP-A1- 3 324 197
- CN-A- 109 765 496
- CN-A- 110 554 328
- CN-U- 215 297 603
- JP-A- H07 183 049
- JP-A- H08 254 573

## Description

### Domaine de l'invention

La présente invention appartient au domaine de la gestion des batteries au plomb. Plus particulièrement, il est proposé une méthode et un dispositif pour détecter une défaillance d'une batterie au plomb.

### Etat de la technique

Les centres de données sont responsables du stockage, du traitement et de la transmission de grandes quantités de données. Ce sont des infrastructures essentielles dans le monde numérique actuel. Les serveurs des centres de données doivent rester opérationnels en permanence, il est donc impératif qu'ils soient alimentés par un système électrique fiable. C'est la raison pour laquelle les centres de données utilisent généralement des systèmes d'alimentation sans interruption (ASI, ou UPS pour « Uninterrupted Power Supply » en anglais).

Les batteries au plomb sont un élément essentiel des systèmes d'alimentation sans interruption pour un serveur de données. Les batteries stockent de l'énergie et, en cas de fluctuations ou de coupures du courant fourni par le réseau électrique, elles peuvent fournir une alimentation de secours pour garantir que le système reste opérationnel. Les batteries jouent un rôle important dans la protection des équipements, l'amélioration de la qualité de l'alimentation et la réponse aux exigences de puissance des centres de données.

Les batteries au plomb sont largement utilisées dans ces systèmes d'alimentation sans interruption en raison de leur faible coût, de leur longue durée de vie et de leur grande fiabilité. Elles sont également bien adaptées pour une utilisation dans des environnements à relativement haute température, ce qui est crucial pour les centres de données.

Les batteries au plomb nécessitent toutefois un entretien et une inspection de façon régulière pour garantir leur bon fonctionnement et éviter d'impacter le centre de données.

Il existe différentes méthodes de détection d'une défaillance d'une batterie au plomb. Par exemple, il est connu du surveiller la tension, la résistance interne, la capacité ou la température de la batterie (une tension basse, une résistance interne élevée, une perte de capacité ou une température élevée peut indiquer une batterie défectueuse). Il est également connu de surveiller la présence de corrosion dans la batterie, ce qui peut entrainer une défaillance prématurée.

La charge d'une batterie au plomb se fait généralement en deux phases successives. Pendant une première phase dite « CC » (acronyme anglais pour « Constant Current », « courant constant » en français) le courant qui circule dans la batterie est maintenue à une valeur sensiblement constante. Pendant cette première phase, la tension aux bornes de la batterie augmente au fur et à mesure que la batterie se recharge. Pendant une deuxième phase dite « CV » (acronyme anglais pour « Constant Voltage », « tension constante » en français) la tension aux bornes de la batterie est maintenue à une valeur sensiblement constante. Pendant cette deuxième phase, le courant suit généralement une fonction décroissante du temps. Le courant qui circule dans la batterie pendant la phase CV est souvent dénommé « courant de floating ». II permet d'empêcher le déchargement naturel de la batterie au plomb.

JPH08254573 A divulgue une méthode pour détecter une défaillance d'une batterie au plomb de l'état de l'art.

Dans le domaine des batteries au lithium, la demande de brevet EP 3324197 A1 décrit une méthode pour déterminer l'état de santé d'une cellule de la batterie en fonction d'un rapport entre une variation de charge et une différence de courant mesurées entre deux instants d'une phase CV (phase de recharge à tension constante) d'un cycle CC-CV (cycle de charge comportant une phase de recharge à courant constant suivi d'une phase de recharge à tension constante).

La fiabilité des méthodes actuelles de détection d'une défaillance d'une batterie au plomb n'est pas toujours pleinement satisfaisante. Aussi, ces méthodes ne permettent généralement pas d'anticiper suffisamment tôt une défaillance de la batterie.

### Exposé de l'invention

La présente invention a pour objectif de remédier à tout ou partie des inconvénients de l'art antérieur, notamment ceux exposés ci-avant.

A cet effet, et selon un premier aspect, il est proposé par la présente invention, une méthode pour détecter une défaillance d'une batterie au plomb. La méthode comporte, pour chaque segment d'une pluralité de segments d'une phase de « tension constante » (phase CV) d'un cycle de charge de la batterie :
- une collecte d'une pluralité de mesures de courant circulant dans la batterie pendant ledit segment, ladite pluralité de mesures formant un signal de « courant de floating » pour ledit segment,
- une décomposition en modes empiriques du signal de courant de floating afin d'en obtenir une représentation sous la forme d'une somme d'un signal résiduel et d'une ou plusieurs composantes intrinsèques,
- un calcul d'une énergie intrinsèque pour chaque composante intrinsèque,
- une détermination d'une énergie intrinsèque maximale parmi les énergies intrinsèques des différentes composantes intrinsèques,
- un calcul d'une énergie intrinsèque totale normalisée en fonction des énergies intrinsèques et de l'énergie intrinsèque maximale,
- une évaluation d'un critère de détection d'une défaillance de la batterie en fonction de l'énergie intrinsèque totale normalisée.

La présente invention trouve une application particulièrement avantageuse, bien que nullement limitative, dans la surveillance d'une batterie au plomb d'un système d'alimentation sans interruption d'un serveur de données. Rien n'empêcherait toutefois d'appliquer la présente invention dans d'autres domaines (les batteries au plomb sont notamment largement utilisées dans l'industrie et dans l'équipement des véhicules ferroviaires et automobiles).

La méthode proposée se distingue nettement des méthodes conventionnelles en ce qu'elle se base sur l'analyse du courant de floating pendant la phase CV d'un cycle de charge de la batterie. Rien ne suggère au premier abord que ce signal renferme des informations pertinentes pour le suivi de l'état de santé de la batterie.

La décomposition en modes empiriques est particulièrement bien adaptée à l'analyse de ce signal. Cette décomposition présente en outre l'avantage d'être relativement rapide et peu gourmande en termes de capacité de calcul.

Le suivi de l'énergie intrinsèque totale normalisée de la batterie permet de détecter une défaillance de façon anticipée et efficace.

Dans des modes particuliers de mise en œuvre, l'énergie intrinsèque totale normalisée est égale à un rapport entre une somme des énergies intrinsèques des différentes composantes et l'énergie intrinsèque maximale.

Dans des modes particuliers de mise en œuvre, l'évaluation du critère de détection d'une défaillance de la batterie comprend une comparaison de l'énergie intrinsèque totale normalisée avec un seuil de défaillance prédéterminé.

Dans des modes particuliers de mise en œuvre, l'évaluation du critère de détection d'une défaillance de la batterie comprend une vérification si l'énergie intrinsèque totale normalisée est supérieure ou égale au seuil de défaillance pour un nombre prédéterminé de segments consécutifs.

Ces différentes conditions peuvent être utilisées de façon individuelle ou en combinaison pour détecter une défaillance de la batterie.

Dans des modes particuliers de mise en œuvre, lorsqu'une défaillance est détectée, la méthode comporte en outre une vérification si la défaillance détectée est liée à l'environnement dans lequel la batterie a évolué.

Dans des modes particuliers de mise en œuvre, la vérification si la défaillance détectée est liée à l'environnement comprend une comparaison, pour une période donnée comportant au moins un segment, de l'énergie intrinsèque totale normalisée calculée pour la batterie pour ledit au moins un segment avec une énergie intrinsèque totale normalisée calculée pour au moins une autre batterie soumise au même environnement pendant ladite période.

Dans des modes particuliers de mise en œuvre, la vérification si la défaillance détectée est liée à l'environnement comprend une comparaison, pour une période donnée comportant au moins un segment, de mesures d'environnement effectuées pendant ladite période avec un seuil prédéterminé.

Il peut en effet être avantageux de savoir si une défaillance détectée est liée à l'environnement dans lequel la batterie évolue. Si la défaillance est liée à l'environnement, il est possible de prendre une mesure corrective au niveau de l'environnement de la batterie, et la défaillance aura potentiellement un impact limité dans le temps. Une défaillance qui n'est pas liée à l'environnement est potentiellement plus grave puisqu'elle présage d'une défaillance intrinsèque à la batterie, comme par exemple une défaillance liée à un défaut de fabrication ou à une dégradation précoce de la batterie. Une défaillance intrinsèque à la batterie peut nécessiter une maintenance pour réparer ou remplacer la batterie défaillante.

Dans des modes particuliers de mise en œuvre, la méthode comporte en outre, pour chaque segment de la pluralité de segments, une estimation d'une fiabilité statistique du segment, en fonction des composantes intrinsèques du signal de courant de floating du segment. Le segment est alors filtré si celui-ci est jugé non fiable.

Dans des modes particuliers de mise en œuvre, la fiabilité statistique du segment est estimée en fonction d'une entropie calculée pour une somme des composantes intrinsèques du signal de courant de floating du segment.

Dans des modes particuliers de mise en œuvre, pour chaque segment de la pluralité de segments, une énergie intrinsèque totale est calculée sous la forme d'une somme des énergies intrinsèques des différentes composantes intrinsèques du segment, et la fiabilité statistique d'un segment est estimée en comparant l'énergie intrinsèque totale du segment avec un seuil d'énergie prédéterminé, ou avec les énergies intrinsèques totales calculées pour au moins un segment précédent.

Cette étape de filtrage permet d'écarter les segments présentant des valeurs aberrantes (segments jugés non fiables statistiquement).

Dans des modes particuliers de mise en œuvre, la batterie fait partie d'un système d'alimentation sans interruption pour un serveur de données.

Selon un deuxième aspect, il est proposé par la présente invention, un dispositif pour détecter une défaillance d'une batterie au plomb. Le dispositif comporte un système de gestion de batterie configuré pour fournir des mesures de courant circulant dans la batterie pendant une phase « tension constante » (phase CV) d'un cycle de charge de la batterie. Le dispositif comporte également une unité de calcul connectée au système de gestion de batterie, ladite unité de calcul est configurée pour mettre en œuvre une méthode selon l'un quelconque des modes de mise en œuvre précédemment décrits.

### Présentation des figures

L'invention sera mieux comprise à la lecture de la description suivante, donnée à titre d'exemple nullement limitatif, et faite en se référant aux figures 1 à 5 suivantes :
[[Fig. 1] une représentation schématique des principales étapes d'un exemple de mise en œuvre de la méthode selon l'invention pour détecter une défaillance d'une batterie au plomb,
[Fig. 2] un graphique représentant l'évolution au cours du temps de l'énergie intrinsèque totale normalisée pour sept batteries différentes soumises à une température supérieure à un seuil maximal de température préconisé pour un fonctionnement normal,
[Fig. 3] un graphique représentant l'évolution au cours du temps de l'énergie intrinsèque totale normalisée pour quatre batteries différentes soumises à une température inférieure au seuil maximal de température,
[Fig. 4] un graphique représentant l'évolution au cours du temps de l'énergie intrinsèque totale normalisée pour une batterie présentant une défaillance intrinsèque (défaut à la conception ou détérioration prématurée de la batterie), une batterie non défaillante soumise à un environnement anormal, et une batterie non défaillante soumise à un environnement normal,
[Fig. 5] une représentation schématique d'un dispositif selon l'invention permettant de détecter une défaillance d'une batterie au plomb.

Dans ces figures, des références identiques d'une figure à une autre désignent des éléments identiques ou analogues. Pour des raisons de clarté, les éléments représentés ne sont pas nécessairement à une même échelle, sauf mention contraire.

### Description détaillée de l'invention

Une batterie au plomb est un accumulateur électrochimique dont les électrodes sont à base de plomb et l'électrolyte est un mélange d'eau et d'acide sulfurique. La batterie peut comporter une ou plusieurs cellules en série assemblées dans un même boîtier. Les électrodes sont généralement des plaques ou des grilles constituées d'un alliage de plomb durci (par exemple à l'aide d'étain, de cadmium et de strontium, à raison de quelques pour cent de l'alliage).

Dans la suite de la description, on se place de manière non limitative dans le cas de la gestion d'une ou plusieurs batteries au plomb d'un système d'alimentation sans interruption d'un serveur de données. Rien n'empêcherait toutefois d'appliquer la présente invention dans d'autres domaines (par exemple pour détecter une défaillance d'une batterie au plomb d'un véhicule automobile).

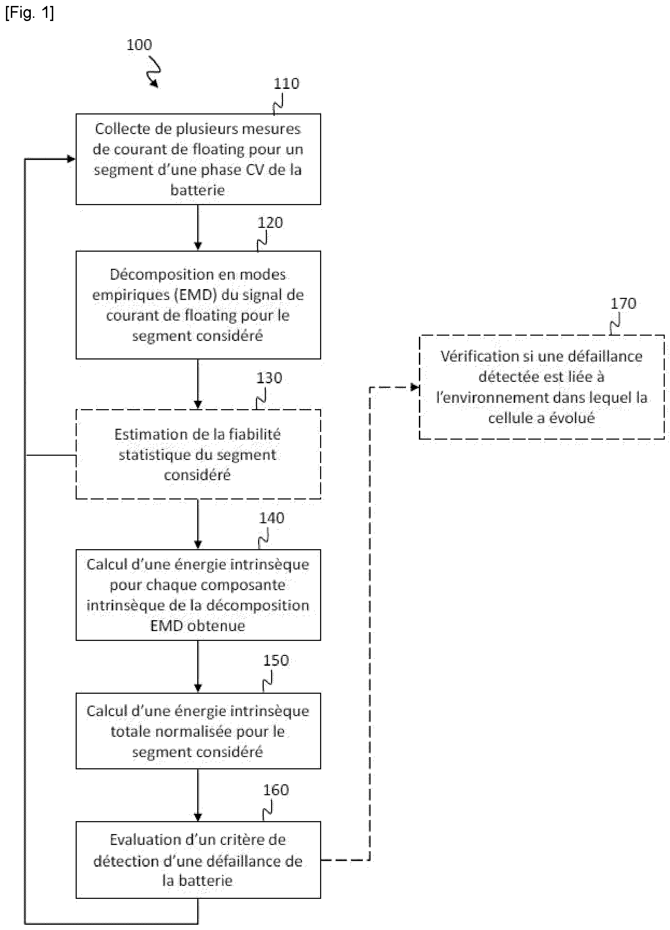

La figure 1 représente schématiquement les principales étapes d'un exemple de mise en oeuvre d'une méthode 100 selon l'invention pour détecter une défaillance d'une batterie au plomb.

Tel qu'illustré sur la figure 1, la méthode 100 comporte les étapes suivantes pour chaque segment d'une pluralité de segments d'une phase de « tension constante », ou phase CV, d'un cycle de charge de la batterie :
- une collecte 110 de plusieurs mesures de courant de floating de la batterie pendant le segment considéré,
- une décomposition en modes empiriques 120 (EMD pour « Empirical Mode Decomposition » en anglais) du signal de courant de floating formé par les mesures obtenues,
- un calcul 140 d'une énergie intrinsèque pour chaque composante intrinsèque obtenue par la décomposition EMD,
- une détermination d'une énergie intrinsèque maximale parmi les énergies intrinsèques des différentes composantes intrinsèques,
- un calcul 150 d'une énergie intrinsèque totale normalisée en fonction des énergies intrinsèques et de l'énergie intrinsèque maximale,
- une évaluation 160 d'un critère de détection d'une défaillance de la batterie en fonction de l'énergie intrinsèque totale normalisée.

Les différents segments correspondent à un découpage temporel de la phase CV considérée. Les mesures de courant de floating sont par exemple effectuées par un système de gestion de batterie (BMS pour « Battery Management System » en anglais) connecté à la batterie. Les mesures sont par exemple effectuées avec une fréquence d'acquisition comprise entre quinze et soixante secondes afin d'obtenir entre deux-cent et huit-cent mesures par segment (dans ce cas la durée d'un segment est alors comprise entre cinquante et huit-cent minutes). Rien n'empêcherait toutefois de faire les mesures avec une fréquence d'acquisition différente, et/ou avec un nombre différent de points par segment. Il est toutefois avantageux d'utiliser un nombre de mesures compris entre deux-cent et huit-cent mesures par segment (utiliser un plus grand nombre de mesures n'implique pas nécessairement une amélioration significative de la méthode, et cela entraine des temps de calcul relativement longs ; utiliser un nombre de mesures plus faible peut en revanche limiter les performances de la méthode). L'ensemble des mesures collectées pendant l'étape de collecte 110 forment un signal de courant de floating.

A l'étape 120, le signal de courant de floating est décomposé selon une décomposition en modes empiriques. Il est à noter que rien ne pouvait laisser présager que ce signal de courant de floating pouvait contenir des informations pertinentes sur l'état de santé de la cellule.

La décomposition en modes empiriques consiste à décomposer un signal sous la forme d'une somme de fonctions, de façon similaire à ce que fait la décomposition en série de Fourier ou la décomposition en ondelettes.

Une des particularités de la décomposition en modes empiriques est que la base de fonctions en lesquelles le signal est décomposé n'est pas connue a priori, mais elle est construite de façon adaptative en fonction des propriétés du signal.

La décomposition en modes empiriques correspond à la première partie de la transformée de Hilbert-Huang (HHT pour « Hilbert-Huang Transform » en anglais). La décomposition en modes empiriques consiste à décomposer un signal sous la forme d'une somme d'un signal résiduel et de fonctions de mode intrinsèque (IMF pour « Intrinsic Mode Function » en anglais). Dans la présente demande, ces fonctions de mode intrinsèque sont également appelées « composantes intrinsèques ».

Comme indiqué précédemment, les composantes intrinsèques ne sont pas définies analytiquement. Elles sont plutôt déterminées de façon adaptative en fonction des propriétés du signal.

Une composante intrinsèque (IMF) résultant d'une décomposition en modes empiriques (EMD) doit satisfaire aux exigences suivantes :
- le nombre d'extrema (c'est-à-dire la somme du nombre des maxima locaux et du nombre des minima locaux) et le nombre de passages par zéro de la composante intrinsèque doivent être égaux ou différer au maximum de un ;
- en tout point de la composante intrinsèque, la valeur moyenne de l'enveloppe définie par les maxima locaux et de l'enveloppe définie par les minima locaux est nulle.

Un signal *s*(*t*) décomposé par EMD peut alors s'écrire sous la forme : $s \left(t\right) = r \left(t\right) + {\sum }_{i = 1}^{N} {c}_{i} \left(t\right)$ Dans cette expression, *r*(*t*) correspond au signal résiduel, *N* est le nombre de composantes intrinsèques de la décomposition EMD, et *cᵢ*(*t*) est la composante intrinsèque d'indice *i*. Chaque composante intrinsèque *cᵢ* successive contient des oscillations de fréquence inférieure à celle de la précédente. Le signal résiduel correspond à une tendance générale du signal *s*(*t*)*.*

La décomposition en modes empiriques comporte une succession de processus de tamisage (« sifting process » en anglais). Le premier processus de tamisage prend en entrée le signal *s*(*t*) directement. Le processus de tamisage correspond à identifier tous les extrema locaux du signal d'entrée, et à relier les maxima locaux, respectivement les minima locaux, par une interpolation par splines cubiques, afin d'obtenir une enveloppe supérieure, respectivement une enveloppe inférieure. Une moyenne entre l'enveloppe supérieure et l'enveloppe inférieure peut alors être calculée et soustraite au signal d'entrée. Si le signal intermédiaire obtenu (soustraction du signal d'entrée avec la moyenne des enveloppes supérieure et inférieure) n'est pas une composante intrinsèque, le processus de tamisage est réitéré sur le signal intermédiaire (qui devient donc le signal d'entrée d'un nouveau processus de tamisage) jusqu'à obtenir une composante intrinsèque. Les processus de tamisage sont répétés jusqu'à obtenir la dernière composante intrinsèque, c'est-à-dire par exemple jusqu'à ce que le signal intermédiaire devienne monotone ou qu'il ne comporte plus qu'un seul extremum local. Le signal restant correspond alors au signal résiduel *r*(*t*).

Un critère d'arrêt peut être défini pour le processus de tamisage. Par exemple le critère d'arrêt est satisfait si l'écart-type entre les résultats de deux processus de tamisage successifs est inférieur ou égale à un seuil d'arrêt prédéterminé. Le seuil d'arrêt peut typiquement être compris entre 0.2 et 0.3.

Le document « The empirical mode decomposition and the Hilbert spectrum for non-linear and non-stationary time series analysis », Norden E. Huang et al., Proc. R. Soc. Lond. A (1998) 454, p. 903-995, décrit de façon détaillée la décomposition en modes empiriques, notamment dans ses sections 4 et 5.

Des algorithmes de décomposition en modes empiriques sont disponibles dans des bibliothèques de programmation, par exemple en langage MATLAB ou Python.

A l'étape 140 une énergie intrinsèque est calculée pour chaque composante intrinsèque obtenue par la décomposition EMD. L'énergie *Eᵢ* d'une composante intrinsèque *cᵢ* correspond par exemple à l'intégrale du carré de l'amplitude de la composante intrinsèque *cᵢ* sur la durée du segment considéré : ${E}_{i} = \int {\left|{c}_{i}\left(t\right)\right|}^{2} dt$

Une énergie intrinsèque maximale *Eₘₐₓ* peut alors être déterminée parmi les énergies intrinsèques *Eᵢ* des différentes composantes intrinsèques : ${E}_{max} = {max}_{i} \left({E}_{i}\right)$

A l'étape 150, une énergie intrinsèque totale normalisée *E̅* est calculée en fonction des énergies intrinsèques *Eᵢ* et de l'énergie intrinsèque maximale *Eₘₐₓ.* L'énergie intrinsèque totale normalisée *E̅* est par exemple égale au rapport entre la somme des énergies intrinsèques *Eᵢ* des différentes composantes intrinsèques *cᵢ* et l'énergie intrinsèque maximale *Eₘₐₓ* : $\overline{E} = \frac{{\sum }_{i = 1}^{N} {E}_{i}}{{E}_{max}}$

Rien n'empêcherait toutefois, dans une variante, de considérer dans la somme des énergies intrinsèques uniquement un sous-ensemble des composantes intrinsèques obtenues par la décomposition EMD (par exemple en considérant seulement un nombre maximum prédéfini des premières composantes intrinsèques obtenues par la décomposition EMD).

A l'étape 160, un critère de détection d'une défaillance de la batterie est évalué en fonction de l'énergie intrinsèque totale normalisée *E̅*.

Différentes conditions peuvent être évaluées, de façon individuelle ou en combinaison, pour détecter une défaillance de la batterie à partir de la valeur d'énergie intrinsèque totale normalisée pour le segment considéré.

L'évaluation 160 du critère de détection d'une défaillance de la batterie peut notamment comprendre une comparaison de l'énergie intrinsèque totale normalisée avec un seuil de défaillance prédéterminé. Par exemple, une défaillance de la batterie est détectée si l'énergie intrinsèque totale normalisée est supérieure ou égale au seuil de défaillance.

L'évaluation 160 du critère de détection d'une défaillance de la batterie peut également comprendre une vérification si l'énergie intrinsèque totale normalisée est supérieure ou égale au seuil de défaillance pour un nombre prédéterminé de segments consécutifs. Par exemple, une défaillance de la batterie est détectée si l'énergie intrinsèque totale normalisée reste supérieure ou égale au seuil de défaillance pour au moins cinq segments consécutifs.

Il est particulièrement intéressant d'utiliser l'énergie intrinsèque totale normalisée. La valeur maximale d'énergie intrinsèque normalisée pour une composante est égale à un (valeur maximale d'énergie intrinsèque normalisée = 1). Si, pour un segment donné, plusieurs composantes ont une énergie intrinsèque particulièrement élevée, l'énergie intrinsèque totale normalisée sera significativement plus grande que un (énergie intrinsèque totale normalisée ≫ 1).

Il est considéré que la valeur d'énergie intrinsèque totale normalisée est liée aux processus de corrosion de la batterie. En effet les processus de corrosion impliquent une multitude d'évènements qui, lors de la normalisation, implique une contribution non négligeable de la majorité des composantes intrinsèques (IMFs) et ainsi une valeur significativement supérieure à un (par exemple au moins égale à deux).

Le seuil de défaillance peut notamment être déterminé en laboratoire de façon empirique. Le seuil de défaillance peut être spécifique à un type particulier de batterie.

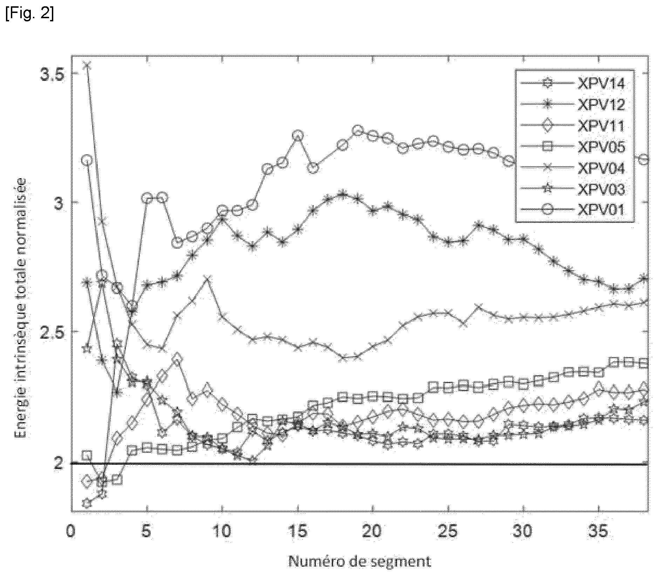

La figure 2 présente un graphique représentant l'évolution au cours du temps de l'énergie intrinsèque totale normalisée pour sept batteries différentes soumises à une température supérieure à 50°C. Cette température correspond à un seuil maximal de température préconisé par le constructeur des batteries pour un fonctionnement normal des batteries. L'axe des ordonnées de ce graphique représente la valeur d'énergie intrinsèque totale normalisée. L'axe des abscisses représente le numéro de segment.

On peut observer sur le graphique de la figure 2 que les sept batteries testées présentent une énergie intrinsèque totale normalisée supérieure à deux à partir du quatrième segment. Ce graphique montre qu'il semble pertinent d'utiliser une valeur de deux pour le seuil de défaillance.

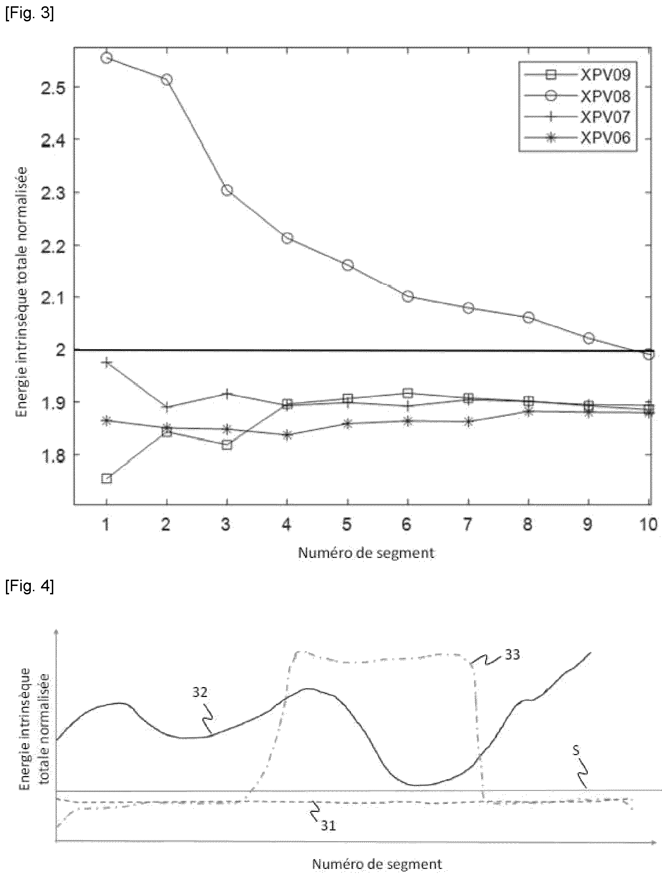

La figure 3 présente un graphique représentant l'évolution au cours du temps de l'énergie intrinsèque totale normalisée pour quatre batteries différentes soumises à une température inférieure au seuil maximal de 50°C. La valeur d'énergie intrinsèque totale normalisée est représentée par l'axe des ordonnées ; l'axe des abscisses représente le numéro de segment.

On peut observer sur le graphique de la figure 3 que seule une des quatre batteries testées présente une énergie intrinsèque totale normalisée supérieure à deux. Ce graphique met en évidence une défaillance de la batterie « XPV08 » pour laquelle énergie intrinsèque totale normalisée est supérieure ou égale au seuil de défaillance pendant les dix segments considérés. Les trois autres batteries ne présentent pas de défaillance sur cette période.

Il peut être avantageux de savoir si une défaillance détectée est liée à l'environnement dans lequel la batterie a évolué. Si la défaillance est liée à l'environnement (par exemple si la défaillance est due à une augmentation anormale de la température du lieu où se trouve la batterie), il est possible de prendre une mesure corrective au niveau de l'environnement de la batterie, et la défaillance aura potentiellement un impact limité dans le temps. Une défaillance qui n'est pas liée à l'environnement est potentiellement plus grave puisqu'elle présage d'une défaillance intrinsèque à la batterie, comme par exemple une défaillance liée à un défaut de fabrication ou à une dégradation précoce de la batterie. Une défaillance intrinsèque à la batterie peut nécessiter une maintenance pour réparer ou remplacer la batterie défaillante.

Dans ce but, et tel qu'illustré sur la figure 1, la méthode 100 peut comporter une étape optionnelle de vérification 170 si une défaillance détectée est liée à l'environnement dans lequel la batterie a évolué.

Cette vérification 170 peut notamment comprendre une comparaison, pour une période donnée comportant au moins un segment, de l'énergie intrinsèque totale normalisée calculée pour la batterie pour ledit au moins un segment avec une énergie intrinsèque totale normalisée calculée pour au moins une autre batterie soumise au même environnement pendant ladite période. Si les valeurs d'énergie intrinsèque totale normalisée calculées pour une ou plusieurs autres batteries soumises au même environnement mettent en évidence une évolution anormale similaire pendant une période donnée, alors il est fortement probable que ce comportement anormal soit lié à l'environnement (par exemple à cause d'une augmentation exceptionnelle de la température subie par les différentes batteries pendant cette période).

Alternativement ou en complément, la vérification 170 peut comprendre une comparaison, pour une période donnée comportant au moins un segment, de mesures d'environnement effectuées et mémorisées pendant ladite période avec un seuil prédéterminé. Il peut s'agir par exemple de mesures de la température subie par la batterie. Si les mesures d'environnement mettent en évidence une évolution anormale de l'environnement pendant la période considérée (par exemple une augmentation exceptionnelle de la température subie par la batterie pendant cette période), alors il est fortement probable qu'une défaillance détectée pendant cette période soit liée à l'environnement.

A titre d'illustration, et de façon nullement limitative, la figure 4 représente graphiquement l'évolution au cours du temps de l'énergie intrinsèque totale normalisée pour trois batteries différentes. L'axe des ordonnées représente la valeur d'énergie intrinsèque totale normalisée ; l'axe des abscisses représente le numéro de segment.

La courbe 31 représente l'évolution au cours du temps de l'énergie intrinsèque totale normalisée pour une batterie non défaillante soumise à un environnement normal. Cette courbe 31 reste de façon continue en-dessous du seuil S de défaillance.

La courbe 32 représente l'évolution au cours du temps de l'énergie intrinsèque totale normalisée pour une batterie présentant une défaillance intrinsèque (par exemple un défaut à la conception ou une détérioration prématurée de la batterie). Cette courbe 31 reste de façon continue au-dessus du seuil S de défaillance. La méthode 100 selon l'invention peut permettre de détecter cette défaillance intrinsèque de la batterie correspondant à la courbe 32.

La courbe 33 représente l'évolution au cours du temps de l'énergie intrinsèque totale normalisée pour une batterie non défaillante soumise à un environnement anormal pendant une certaine période de temps. Pendant cette période, la batterie est par exemple exposée à une température exceptionnellement élevée, ce qui entraine un fonctionnement anormal de la batterie. Tel qu'illustré par la courbe 33 sur le graphique de la figure 4, l'énergie intrinsèque totale normalisée de la batterie est supérieure au seuil S de défaillance pendant la période de temps où la température est anormalement élevée. En dehors de cette période de temps, l'énergie intrinsèque totale normalisée de la batterie est inférieure au seuil S de défaillance. La méthode 100 selon l'invention peut permettre de détecter la défaillance de la batterie correspondant à la courbe 33. La méthode 100 selon l'invention peut également permettre de détecter si cette défaillance est due à des conditions anormales de l'environnement dans lequel la batterie évolue. Par exemple, des mesures de températures anormalement élevées mesurées pendant la période de temps où la défaillance est détectée suggèrent que cette défaillance est due à des conditions anormales de l'environnement. Selon un autre exemple, un comportement anormal similaire observé pendant la même période de temps pour d'autres batteries soumises au même environnement suggère également que cette défaillance est due à des conditions anormales de l'environnement.

Tel qu'illustré sur la figure 1, la méthode 100 selon l'invention peut également comporter une étape optionnelle d'estimation 130 de la fiabilité statistique du segment considéré, et un filtrage du segment si celui-ci est jugé non fiable (le segment et les mesures associées sont alors ignorés, c'est-à-dire qu'ils ne sont pas pris en compte dans l'évaluation 160 du critère de défaillance).

Ce filtrage d'un segment jugé non fiable permet d'éviter de prendre en compte des valeurs aberrantes dans l'analyse de l'état de santé de la batterie.

La fiabilité statistique d'un segment est estimée en fonction des composantes intrinsèques du signal de courant de floating obtenues pour le segment.

Selon un premier exemple, la fiabilité statistique du segment est estimée en fonction d'une entropie calculée pour une somme des composantes intrinsèques du signal de courant de floating (par exemple pour la somme de l'ensemble des composantes intrinsèques obtenues par la décomposition EMD, ou pour la somme d'un nombre maximum prédéfini des premières composantes intrinsèques obtenues par la décomposition EMD). Différentes méthodes de calcul d'entropie peuvent être envisagés, comme par exemple un calcul d'entropie de Shannon, ou un calcul d'entropie de Kolmogorov. Par exemple, les segments pour lesquelles l'entropie calculée est trop faible (inférieure à un seuil d'entropie prédéterminé) sont filtrés. Un seuil d'entropie de Shannon compris entre 0.25 et 0.5 peut notamment être envisagé.

Selon un deuxième exemple, une énergie intrinsèque totale égale à une somme des énergies intrinsèques des différentes composantes intrinsèques du segment est calculée (là encore, il est envisageable de considérer l'ensemble de toutes les composantes intrinsèques obtenues par la décomposition EMD, ou seulement un sous-ensemble de ces composantes intrinsèques). La fiabilité statistique d'un segment est estimée en comparant l'énergie intrinsèque totale calculée pour le segment avec un seuil d'énergie prédéterminé. Par exemple, les segments qui présentent une valeur d'énergie intrinsèque totale aberrante (supérieure au seuil d'énergie) sont filtrés.

Selon encore un autre exemple, la fiabilité statistique d'un segment est estimée en comparant l'énergie intrinsèque totale calculée pour le segment avec les énergies intrinsèques totales calculées pour tout ou partie des segments précédents (par exemple les énergies intrinsèques totales peuvent être comparées entre elles, ou bien l'énergie intrinsèque totale du segment courant peut être comparée à une valeur moyenne des énergies intrinsèques totales de segments précédents). Différents tests statistiques peuvent être envisagés dans ce but (test de Pierce, test de Pierson, etc.).

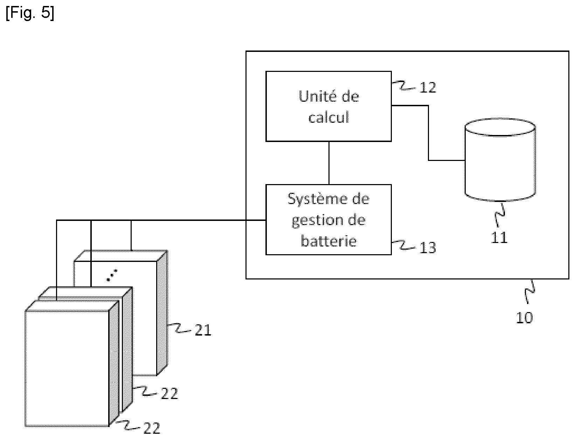

La figure 5 représente schématiquement un dispositif 10 pour détecter une défaillance d'une batterie 21 au plomb. Le dispositif 10 comporte notamment une mémoire 11, un système de gestion 13 de batterie et une unité de calcul 12 connectée à la mémoire 11 et au système de gestion 13 de batterie.

Le système de gestion 13 de batterie est configuré pour fournir des mesures de courant effectuées au niveau de la batterie 21 pendant au moins un segment une phase CV de la batterie.

L'unité de calcul 12 est configurée pour mettre en œuvre la méthode 100 selon l'un quelconque des modes de mise en œuvre décrits ci-avant.

Le dispositif 10 peut en outre comporter un capteur configuré pour mesurer l'environnement (par exemple un capteur de température).

Le système de gestion 13 de batterie peut également être configuré pour fournir des mesures de courant de floating d'une ou plusieurs autres batteries 22 soumises à un même environnement que la batterie 21.

La description ci-avant illustre clairement que, par ses différentes caractéristiques et leurs avantages, la présente invention atteint les objectifs fixés. En particulier, le suivi de l'énergie intrinsèque totale normalisée de la batterie permet efficacement de détecter une défaillance de façon anticipée.

## Revendications

1. Méthode (100) pour détecter une défaillance d'une batterie (21) au plomb, la méthode (100) comportant, pour chaque segment d'une pluralité de segments d'une phase de « tension constante », ou phase CV, d'un cycle de charge de la batterie :
- une collecte (110) d'une pluralité de mesures de courant circulant dans la batterie (21) pendant ledit segment, ladite pluralité de mesures formant un signal de « courant de floating » pour ledit segment,
**caractérisée en ce que** la méthode comporte en outre :
- une décomposition en modes empiriques (120) du signal de courant de floating afin d'en obtenir une représentation sous la forme d'une somme d'un signal résiduel et d'une ou plusieurs composantes intrinsèques,
- un calcul (140) d'une énergie intrinsèque pour chaque composante intrinsèque,
- une détermination d'une énergie intrinsèque maximale parmi les énergies intrinsèques des différentes composantes intrinsèques,
- un calcul (150) d'une énergie intrinsèque totale normalisée en fonction des énergies intrinsèques et de l'énergie intrinsèque maximale,
- une évaluation (160) d'un critère de détection d'une défaillance de la batterie (21) en fonction de l'énergie intrinsèque totale normalisée.

2. Méthode (100) selon la revendication 1 dans laquelle l'énergie intrinsèque totale normalisée est égale à un rapport entre une somme des énergies intrinsèques des différentes composantes et l'énergie intrinsèque maximale.

3. Méthode (100) selon l'une des revendications précédentes dans laquelle l'évaluation (160) du critère de détection d'une défaillance de la batterie (21) comprend une comparaison de l'énergie intrinsèque totale normalisée avec un seuil de défaillance prédéterminé.

4. Méthode (100) selon l'une des revendications précédentes dans laquelle l'évaluation (160) du critère de détection d'une défaillance de la batterie (21) comprend une vérification si l'énergie intrinsèque totale normalisée est supérieure ou égale au seuil de défaillance pour un nombre prédéterminé de segments consécutifs.

5. Méthode (100) selon l'une quelconque des revendications 1 à 4 dans laquelle, lorsqu'une défaillance est détectée, la méthode comporte en outre une vérification (170) si la défaillance détectée est liée à l'environnement dans lequel la batterie (21) a évolué.

6. Méthode (100) selon la revendication 5, dans laquelle la vérification (170) si la défaillance détectée est liée à l'environnement comprend une comparaison, pour une période donnée comportant au moins un segment, de l'énergie intrinsèque totale normalisée calculée pour la batterie (21) pour ledit au moins un segment avec une énergie intrinsèque totale normalisée calculée pour au moins une autre batterie (22) soumise au même environnement pendant ladite période.

7. Méthode (100) selon l'une quelconque des revendications 5 à 6, dans laquelle la vérification (170) si la défaillance détectée est liée à l'environnement comprend une comparaison, pour une période donnée comportant au moins un segment, de mesures d'environnement effectuées pendant ladite période avec un seuil prédéterminé.

8. Méthode (100) selon l'une quelconque des revendications 1 à 7, comportant en outre, pour chaque segment de la pluralité de segments, une estimation (130) d'une fiabilité statistique du segment, en fonction des composantes intrinsèques du signal de courant de floating du segment, et un filtrage du segment si celui-ci est jugé non fiable.

9. Méthode (100) selon la revendication 8, dans laquelle la fiabilité statistique du segment est estimée en fonction d'une entropie calculée pour une somme des composantes intrinsèques du signal de courant de floating du segment.

10. Méthode (100) selon l'une quelconque des revendications 8 à 9 dans laquelle, pour chaque segment de la pluralité de segments, une énergie intrinsèque totale est calculée sous la forme d'une somme des énergies intrinsèques des différentes composantes intrinsèques du segment, et la fiabilité statistique d'un segment est estimée en comparant l'énergie intrinsèque totale du segment avec un seuil d'énergie prédéterminé, ou avec les énergies intrinsèques totales calculées pour au moins un segment précédent.

11. Méthode (100) selon l'une quelconque des revendications 1 à 10, dans laquelle la batterie (21) fait partie d'un système d'alimentation sans interruption pour un serveur de données.

12. Dispositif (10) pour détecter une défaillance d'une batterie (21) au plomb, ledit dispositif (10) comportant :
- un système de gestion (13) de batterie configuré pour fournir des mesures de courant circulant dans la batterie (21) pendant une phase « tension constante », ou phase CV, d'un cycle de charge de la batterie (21),
- une unité de calcul (12) connectée au système de gestion (13) de batterie, ladite unité de calcul (12) étant configurée pour mettre en œuvre une méthode selon l'une quelconque des revendications 1 à 11.

## Patentansprüche

1. Verfahren (100) zum Erkennen eines Fehlers einer Bleibatterie (21), wobei das Verfahren (100) für jedes Segment einer Vielzahl von Segmenten einer "Konstantspannungs"-Phase, oder CV-Phase, eines Ladezyklus der Batterie beinhaltet:
- ein Erheben (110) einer Vielzahl von Messungen von Strom, der während des Segments in der Batterie (21) fließt, wobei die Vielzahl von Messungen ein "Floating-Strom"-Signal für das Segment bildet,
**dadurch gekennzeichnet, dass** das Verfahren weiter beinhaltet:
- eine Zerlegung in empirische Modi (120) des Floating-Strom-Signals, um daraus eine Darstellung in Form einer Summe aus einem Restsignal und einer oder mehreren intrinsischen Komponenten zu erhalten,
- ein Berechnen (140) einer intrinsischen Energie für jede intrinsische Komponente,
- ein Bestimmen einer maximalen intrinsischen Energie aus den intrinsischen Energien der verschiedenen intrinsischen Komponenten,
- ein Berechnen (150) einer normierten intrinsischen Gesamtenergie in Abhängigkeit von den intrinsischen Energien und der maximalen intrinsischen Energie,
- ein Bewerten (160) eines Erkennungskriteriums für einen Fehler der Batterie (21) in Abhängigkeit von der normierten intrinsischen Gesamtenergie.

2. Verfahren (100) nach Anspruch 1, wobei die normierte intrinsische Gesamtenergie gleich einem Verhältnis zwischen einer Summe der intrinsischen Energien der verschiedenen Komponenten und der maximalen intrinsischen Energie ist.

3. Verfahren (100) nach einem der vorstehenden Ansprüche, wobei das Bewerten (160) des Erkennungskriteriums für einen Fehler der Batterie (21) einen Vergleich der normierten intrinsischen Gesamtenergie mit einem vorbestimmten Fehlerschwellenwert umfasst.

4. Verfahren (100) nach einem der vorstehenden Ansprüche, wobei das Bewerten (160) des Erkennungskriteriums für einen Fehler der Batterie (21) eine Verifizierung umfasst, ob die normierte intrinsische Gesamtenergie größer oder gleich dem Fehlerschwellenwert für eine vorbestimmte Anzahl aufeinanderfolgender Segmente ist.

5. Verfahren (100) nach einem der Ansprüche 1 bis 4, wobei das Verfahren, wenn ein Fehler erkannt wird, weiter eine Verifizierung (170) beinhaltet, ob der erkannte Fehler mit der Umgebung zusammenhängt, in der sich die Batterie (21) entwickelt hat.

6. Verfahren (100) nach Anspruch 5, wobei die Verifizierung (170), ob der erkannte Fehler mit der Umgebung zusammenhängt, einen Vergleich, für einen bestimmten Zeitraum, der mindestens ein Segment, der für die Batterie (21) für das mindestens eine Segment berechneten normierten intrinsischen Gesamtenergie mit einer für mindestens eine andere Batterie (22) berechneten normierten intrinsischen Gesamtenergie umfasst, die während des Zeitraums derselben Umgebung ausgesetzt ist, beinhaltet.

7. Verfahren (100) nach einem der Ansprüche 5 bis 6, wobei die Verifizierung (170), ob der erkannte Fehler mit der Umgebung zusammenhängt, einen Vergleich für einen gegebenen Zeitraum, der mindestens ein Segment beinhaltet, von während des Zeitraums durchgeführten Umgebungsmessungen mit einem vorbestimmten Schwellenwert umfasst.

8. Verfahren (100) nach einem der Ansprüche 1 bis 7, das weiter für jedes Segment der Vielzahl von Segmenten ein Schätzen (130) einer statistischen Zuverlässigkeit des Segments in Abhängigkeit von den intrinsischen Komponenten des Floating-Strom-Signals und ein Filtern des Segments beinhaltet, wenn dieses als unzuverlässig beurteilt wird.

9. Verfahren (100) nach Anspruch 8, wobei die statistische Zuverlässigkeit des Segments in Abhängigkeit von einer Entropie geschätzt wird, die für eine Summe der intrinsischen Komponenten des Floating-Strom-Signals des Segments berechnet wird.

10. Verfahren (100) nach einem der Ansprüche 8 bis 9, wobei für jedes Segment der Vielzahl von Segmenten eine intrinsische Gesamtenergie in Form einer Summe der intrinsischen Energien der verschiedenen intrinsischen Komponenten des Segments berechnet wird, und die statistische Zuverlässigkeit eines Segments durch Vergleichen der intrinsischen Gesamtenergie des Segments mit einem vorbestimmten Energieschwellenwert oder mit den für mindestens ein vorheriges Segment berechneten intrinsischen Gesamtenergien geschätzt wird.

11. Verfahren (100) nach einem der Ansprüche 1 bis 10, wobei die Batterie (21) Teil eines unterbrechungsfreien Stromversorgungssystems für einen Datenserver ist.

12. Vorrichtung (10) zum Erkennen eines Fehlers einer Bleibatterie (21), wobei die Vorrichtung (10) beinhaltet:
- ein Batteriemanagementsystem (13), das konfiguriert ist, um Messungen des Stroms bereitzustellen, der in der Batterie (21) während einer "Konstantspannungs"-Phase, oder CV-Phase, eines Ladezyklus der Batterie (21) fließt,
- eine Recheneinheit (12), die mit dem Batteriemanagementsystem (13) verbunden ist, wobei die Recheneinheit (12) konfiguriert ist, um ein Verfahren nach einem der Ansprüche 1 bis 11 umzusetzen.

## Claims

1. Method (100) for detecting a failure of a lead-acid battery (21), the method (100) comprising, for each segment of a plurality of segments of a "constant voltage" phase, or CV phase, of a charging cycle of the battery:
- collecting (110) a plurality of measurements of current flowing in the battery (21) during said segment, said plurality of measurements forming a "floating current" signal for said segment,
**characterized in that** the method further comprises:
- decomposing into empirical modes (120) the floating current signal in order to obtain therefrom a representation in the form of a sum of a residual signal and of one or more intrinsic component(s),
- calculating (140) an intrinsic energy for each intrinsic component,
- determining a maximum intrinsic energy among the intrinsic energies of the different intrinsic components,
- calculating (150) a normalized total intrinsic energy according to the intrinsic energies and the maximum intrinsic energy,
- evaluating (160) a criterion for detecting a failure of the battery (21) according to the normalized total intrinsic energy.

2. Method (100) according to claim 1, wherein the normalized total intrinsic energy is equal to a ratio between a sum of the intrinsic energies of the different components and the maximum intrinsic energy.

3. Method (100) according to one of the preceding claims wherein evaluating (160) the criterion for detecting a failure of the battery (21) comprises comparing the normalized total intrinsic energy with a predetermined failure threshold.

4. Method (100) according to one of the preceding claims wherein evaluating (160) the criterion for detecting a failure of the battery (21) comprises verifying whether the normalized total intrinsic energy is greater than or equal to the failure threshold for a predetermined number of consecutive segments.

5. Method (100) according to any one of claims 1 to 4, wherein, when a failure is detected, the method further comprises verifying (170) whether the detected failure is related to the environment wherein the battery (21) has developed.

6. Method (100) according to claim 5, wherein verifying (170) whether the detected failure is related to the environment comprises comparing, for a given period comprising at least one segment, the normalized total intrinsic energy calculated for the battery (21) for said at least one segment with a normalized total intrinsic energy calculated for at least one other battery (22) subjected to the same environment during said period.

7. Method (100) according to any one of claims 5 to 6, wherein verifying (170) whether the detected failure is related to the environment comprises comparing, for a given period comprising at least one segment, environment measurements performed during said period with a predetermined threshold.

8. Method (100) according to any one of claims 1 to 7, further comprising, for each segment of the plurality of segments, estimating (130) a statistical reliability of the segment, according to the intrinsic components of the floating current signal of the segment, and filtering the segment if the latter is found to be unreliable.

9. Method (100) according to claim 8, wherein the statistical reliability of the segment is estimated according to an entropy calculated for a sum of the intrinsic components of the floating current signal of the segment.

10. Method (100) according to any one of claims 8 to 9 wherein, for each segment of the plurality of segments, a total intrinsic energy is calculated in the form of a sum of the intrinsic energies of the different intrinsic components of the segment, and the statistical reliability of a segment is estimated by comparing the total intrinsic energy of the segment with a predetermined energy threshold, or with the total intrinsic energies calculated for at least one previous segment.

11. Method (100) according to any one of claims 1 to 10, wherein the battery (21) is part of an uninterruptible power supply system for a data server.

12. Device (10) for detecting a failure of a lead-acid battery (21), said device (10) comprising:
- a battery management system (13) configured to provide measurements of current flowing in the battery (21) during a "constant voltage" phase, or CV phase, of a charging cycle of the battery (21),
- a computing unit (12) connected to the battery management system (13), said computing unit (12) being configured to implement a method according to any one of claims 1 to 11.
